# EUROPÄISCHE PATENTSCHRIFT

(11) **EP 3 590 315 B1**
(45) Veröffentlichungstag und Bekanntmachung des Hinweises auf die Patenterteilung: **09.06.2021**
(21) Anmeldenummer: 18705162.8
(22) Anmeldetag: 21.02.2018
(51) Int. Cl.: H05K 7/20

(54) **ONLINE-USV-ANLAGE MIT KOMBINIERTER LUFT- UND WASSERKÜHLUNG**
ONLINE UPS INSTALLATION WITH COMBINED AIR AND WATER COOLING
INSTALLATION USV EN LIGNE COMPRENANT UN REFROIDISSEMENT D'EAU ET D'AIR COMBINÉ

(30) Priorität: 28.02.2017 EP 17158432
(43) Veröffentlichungstag der Anmeldung: 08.01.2020
(73) Patentinhaber: Piller Group GmbH, 37520 Osterode am Harz (DE)
(72) Erfinder: HUNTGEBURTH, Joachim, 37115 Duderstadt (DE); BENKE, Thomas, 99734 Nordhausen (DE)
(74) Vertreter: REHBERG HÜPPE + PARTNER
(86) Internationale Anmeldenummer: PCT/EP2018/054199
(87) Internationale Veröffentlichungsnummer: WO 2018/158115

(56) Entgegenhaltungen:
- EP-A2- 1 961 281
- US-A1- 2010 085 708

## Beschreibung

### TECHNISCHES GEBIET DER ERFINDUNG

Die Erfindung bezieht sich auf eine USV-Anlage, bei der folgende Bestandteile in einem Maschinenschrank angeordnet sind: (i) ein ausgangsseitig an einen Gleichspannungszwischenkreis angeschlossener AC/DC-Wandler mit einer Leistungsendstufe, (ii) ein eingangsseitig an den Gleichspannungszwischenkreis angeschlossener DC/AC-Wandler mit einer weiteren Leistungsendstufe, (iii) ein an den Gleichspannungszwischenkreis angeschlossener bidirektionaler DC/AC-Wandler mit noch einer weiteren Leistungsendstufe, (iv) ein AC-seitig an den bidirektionalen DC/AC-Wandler angeschlossener Motor/Generator, an dessen Rotor eine Schwungmasse mechanisch angekoppelt ist, (v) ein Bypass zu der Reihenschaltung des AC/DC-Wandlers mit dem DC/AC-Wandler, in dem ein Bypassschalter angeordnet ist, (vi) eine Steuerung für den AC/DC-Wandler, den DC/AC-Wandler, den Motor/Generator und den Bypassschalter sowie (vii) ein Luft aus einer Umgebung des Maschinenschranks durch Luftfilter in den Maschinenschrank einsaugendes, die Luft in dem Maschinenschrank durch einen Wärmetauscher blasendes und die Luft wieder aus dem Maschinenschrank ausstoßendes Gebläse.

Aufgrund der Reihenschaltung des AC/DC-Wandlers mit dem DC/AC-Wandler ist diese USV-Anlage eine sogenannte Online-USV, die an den Ausgang des DC/AC-Wandlers angeschlossene Lasten über diese Reihenschaltung aus einer Hauptwechselstromquelle versorgen kann. Dabei kann mit Hilfe der Reihenschaltung des AC/DC-Wandlers mit dem DC/AC-Wandler die Qualität des der Last zur Verfügung gestellten Wechselstroms gegenüber der Hauptwechselstromquelle verbessert werden. Wenn jedoch bereits die Ausgangsqualität des Wechselstroms ausreichend ist, kann die Last unter Umgehung des AC/DC-Wandlers und des DC/AC-Wandlers über den Bypass direkt aus der Hauptwechselstromquelle versorgt werden. Bei teilweisem oder auch vollständigem Ausfall der Hauptwechselstromquelle kann die Last über den Motor/Generator, den bidirektionaler DC/AC-Wandler und den DC/AC-Wandler aus der Schwungmasse versorgt werden. Dazu ist die Schwungmasse zuvor über den AC/DC-Wandler, den bidirektionaler DC/AC-Wandler und den Motor/Generator in Rotation zu versetzen, um kinetische Energie in ihr zu speichern.

Insbesondere handelt es sich bei der USV-Anlage um eine kompakte, in einem Maschinenschrank angeordnete USV-Anlage mit bezogen auf Ihre Abmessungen hoher Leistungsdichte. Bei einer derart hohen Leistungsdichte bedarf der Wärmehaushalt der USV-Anlage besonderer Beachtung.

### STAND DER TECHNIK

Aus der EP 1 226 643 B1 ist eine USV-Anlage mit einem Gehäuse, einer Schwungrad-Energiespeicher-Einheit, die eine Kurzzeit-Reserveenergie für einen Verbraucher bereitstellt und in dem Gehäuse angeordnet ist, und einer USV-Elektronikeinheit bekannt, die dem Verbraucher kontinuierlich Leistung von einer der folgenden Leistungsquellen zuführt: der Schwungradeinheit, einer Netzspannungsversorgung und einer Langzeit-Notstromquelle, die ebenfalls in dem Gehäuse angeordnet ist. Ein Kühlsystem zum Kühlen der Schwungradeinheit und der USV-Elektronikeinheit weist ein Zwangsluft-Konvektionskühlsystem auf, das Kühlluft über die Schwungradeinheit und die USV-Elektronikeinheit leitet. Konkret leitet das Konvektionskühlsystem die Kühlluft zunächst über die Schwungradeinheit und dann über die USV-Elektronikeinheit. Weiterhin weist das Konvektionskühlsystem mehrere Gebläse und jedes Gebläse ein Dämpfungselement auf, das durch das Gebläse angesaugte Luft wieder aus dem Gehäuse herausleitet. Die Dämpfungselemente weisen jeweils eine Klappe auf, die in Abhängigkeit von der Druckdifferenz zwischen dem Innen- und dem Außendruck des Gehäuses geöffnet und geschlossen wird. Das Gehäuse umfasst eine stabile Basis, an der die Schwungradeinheit gelagert ist, und einen an der Basis montierten Rahmen, der eine Steuerungselektronik für die Schwungradeinheit und die USV-Elektronikeinheit hält. Die Basis und der Rahmen des Gehäuses sind gemeinsam durch Seitenpaneele und Zugangstürpaneele sowie einen Deckel, in dem die Klappen vorgesehen sind, verkleidet.

Aus der DE 198 52 125 C1 ist eine Vorrichtung zur unterbrechungsfreien Stromversorgung bekannt, die zwischen eine Wechselstromquelle, deren Unterbrechungen zu überbrücken sind, und einen oder mehrere mit Wechselstrom zu versorgende Verbraucher zu schalten ist. Die Vorrichtung umfasst mindestens einen Gleichrichter für den ankommenden Wechselstrom, Akkumulatoren für das Zwischenspeichern elektrischer Energie, mindestens einen Wechselrichter für die Batteriespannung der Akkumulatoren und eine Steuerelektronik. Elektrische Wickelkörper, insbesondere Spulen und Drosseln, und elektronische Halbleiterbausteine der Vorrichtung werden von einem Leistungsstrom durchflossen. Die Wickelkörper sind in einem mit einer ersten Kühlflüssigkeit befüllten Becken angeordnet. Ein Leitungssystem für eine zweite Kühlflüssigkeit weist dem ersten Kühlmittel und den Halbleiterbausteinen zugewandte Wärmeaustauschflächen auf. Für die erste Kühlflüssigkeit ist ein Druckausgleichsmittel vorgesehen, das ein komprimierbares Gasvolumen aufweist. Für die zweite Kühlflüssigkeit ist ein Wärmetauscher vorgesehen, um dieser Wärme zu entziehen. Bei der bekannten Vorrichtung zur unterbrechungsfreien Stromversorgung wird, um den Aufbau von Verschmutzungen zu vermeiden, keine Kühlluft von außen durch die Vorrichtung hindurchgeführt. Sie weist ein geschlossenes Gehäuse für alle elektronischen und elektrischen Bestandteile auf, aus dem bzw. in das nur Stromleitungen und Leitungen für die zweite Kühlflüssigkeit heraus- bzw. hereinführen. Der Wärmetauscher ist außerhalb dieses Gehäuses angeordnet.

Aus der US 2010/0085708 A1 ist eine USV-Anlage mit direkter Kühlung verschiedener ihrer Abwärme erzeugenden Komponenten bekannt. Die Abwärme erzeugenden Komponenten der USV-Anlage sind in einem Schaltschrank angeordnet und umfassen einen Gleichrichter, einen Wechselrichter, einen Schalter und mindestens einen Transformator. Dabei werden der Gleichrichter, der Wechselrichter und der Schalter mit Kühlplatten gekühlt, die von einer Kühlflüssigkeit durchströmt werden. Die Kühlflüssigkeit wird mit einer Pumpe in einem Kühlmittelkreislauf umgewälzt, in dem ein Wärmetauscher angeordnet ist. In dem Wärmetauscher wird die Abwärme von der Kühlflüssigkeit an Luft abgegeben, mit der der Transformator luftgekühlt wird. Als Energiespeicher verwendet die bekannte USV-Anlage eine Batterie. Als andere Möglichkeit einer Notstromversorgung ist diejenige aus einem Schwungrad angegeben.

Aus der WO 2007/065666 A2 ist eine USV mit einer Kühlvorrichtung aus einem Luftkühler bekannt, an den ein Flüssigkeitskühler anmontiert ist. Dabei ist der Luftkühler zwischen dem Flüssigkeitskühler und Wärme erzeugenden elektrischen Komponenten, insbesondere Leistungshalbleitern, als Wärmebrücke zwischen den Wärme erzeugenden Komponenten und dem Flüssigkeitskühler angeordnet. Der Flüssigkeitskühler dient zur Erhöhung der Kühlleistung der Kühlvorrichtung gegenüber ihrer Ausbildung nur mit dem Luftkühler.

### AUFGABE DER ERFINDUNG

Der Erfindung liegt die Aufgabe zugrunde, eine USV-Anlage der eingangs beschriebenen Art, die dem Oberbegriff des unabhängigen Patentanspruchs 1 entspricht, hinsichtlich ihres Kühlsystems so zu verbessern, dass ihre Leistungsdichte erhöht werden kann, ohne dass Probleme mit ihrem Wärmehaushalt auftreten.

### LÖSUNG

Die Aufgabe der Erfindung wird durch eine USV-Anlage mit den Merkmalen des unabhängigen Patentanspruchs 1 gelöst. Bevorzugte Ausführungsformen der erfindungsgemäßen USV-Anlage sind in den abhängigen Patentansprüchen definiert.

### BESCHREIBUNG DER ERFINDUNG

Eine erfindungsgemäße USV-Anlage weist einen Maschinenschrank und die folgenden Bestandteile auf, die in dem Maschinenschrank angeordnet sind: (i) ein ausgangsseitig an einen Gleichspannungszwischenkreis angeschlossener AC/DC-Wandler mit einer Leistungsendstufe, (ii) ein eingangsseitig an den Gleichspannungszwischenkreis angeschlossener DC/AC-Wandler mit einer weiteren Leistungsendstufe, (iii) ein an den Gleichspannungszwischenkreis angeschlossener bidirektionaler DC/AC-Wandler mit noch einer weiteren Leistungsendstufe, (iv) ein AC-seitig an den bidirektionalen DC/AC-Wandler angeschlossener Motor/Generator, an dessen Rotor eine Schwungmasse mechanisch angekoppelt ist, (v) ein Bypass zu der Reihenschaltung des AC/DC-Wandlers mit dem DC/AC-Wandler, in dem ein Bypassschalter angeordnet ist, (vi) eine Steuerung für den AC/DC-Wandler, den DC/AC-Wandler, den Motor/Generator und den Bypassschalter sowie (vii) ein Luft aus einer Umgebung des Maschinenschranks durch Luftfilter in den Maschinenschrank einsaugendes, die Luft in dem Maschinenschrank durch einen Wärmetauscher blasendes und die Luft wieder aus dem Maschinenschrank ausstoßendes Gebläse. Dabei ist der Wärmetauscher erfindungsgemäß zusammen mit einer Kühlmittelpumpe, Kühlmittelkanälen durch den Motor/Generator und Kühlkörpern für die Leistungsendstufen in einem geschlossenen Kühlmittelkreislauf angeordnet, wobei die Kühlmittelkanäle durch den Motor/Generator Statorkanäle umfassen, die durch einen Stator des Motor/Generators verlaufen.

Die erfindungsgemäße USV-Anlage weist ein hybrides Kühlsystem auf, das die Wärmekapazität von Luft aus der Umgebung sowohl für eine Grundkühlung der in dem Maschinenschrank angeordneten Bestandteile als auch für eine verstärkte Wärmeabfuhr von kritischen Bestandteilen mit Hilfe eines Kühlmittels nutzt. Das Kühlmittel wird in dem Wärmetauscher abgekühlt, durch den die in den Maschinenschrank eingesaugte Luft in den Maschinenschrank geblasen wird, bevor sie wieder aus dem Maschinenschrank ausgestoßen wird. Das Kühlmittel wird von einer Kühlmittelpumpe durch einen Kühlmittelkreislauf zirkuliert, in dem neben dem Wärmetauscher Kühlmittelkanäle durch den Motor/Generator und Kühlkörper für die Leistungsendstufen angeordnet sind. Zumindest werden also der Motor/Generator und die Leistungsendstufen der Wandler mit Hilfe des Kühlmittels gekühlt. Dies schließt jedoch nicht aus, dass auch noch für weitere Bestandteile der USV-Anlage innerhalb des Maschinenschranks eine Kühlmittelkühlung vorgesehen wird. Beispielsweise die Steuerung der USV-Anlage wird aber regelmäßig ausreichend mit Luft gekühlt, da die hierdurch fließenden elektrischen Leistungen nur klein sind. Weiter ist zu berücksichtigen, dass in der Steuerung keine größeren Spannungen auftreten, die bei Verunreinigungen innerhalb des Maschinenschranks mit einer relevanten Gefahr von Durchschlägen verbunden wären. Dort wo größere Spannungen in der erfindungsgemäßen USV-Anlage auftreten, wie beispielsweise bei den Leistungsendstufen der Wandler, kommt die Kühlmittelkühlung zum Einsatz. Zudem wird durch die Luftfilter, durch die hindurch die Luft in den Maschinenschrank eingesaugt wird, einer Verunreinigung des Inneren des Maschinenschranks vorgebeugt.

Ungewöhnlich ist bei der erfindungsgemäßen USV-Anlage die Einbindung des Motor/Generators in den Kühlmittelkreislauf. Dies erlaubt jedoch eine ganz erhebliche Steigerung der Leistungsdichte der USV-Anlage in Bezug auf die kinetischen Energie, die in der mechanisch an den Rotor des Motor/Generators angekoppelten Schwungmasse gespeichert wird. Das Kühlmittel, das durch die Statorkanäle durch den Stator des Motor/Generators fließt, kühlt nicht nur den Stator selbst, sondern auch die Lager für den Rotor des Motor/Generators.

Es ist bevorzugt, wenn die Kühlmittelkanäle durch den Motor/Generator weiterhin Gehäusekanäle umfassen, die durch ein Gehäuse des Motor/Generators verlaufen. Wenn sowohl der Stator als auch das Gehäuse des Motor/Generators durch Kühlmittel gekühlt wird, wird auch eine indirekte Kühlung des dazwischen rotierenden Rotors des Motor/Generators erreicht. Dies gilt insbesondere dann, wenn das Gehäuse des Motor/Generators nicht nur den Rotor, sondern auch die daran mechanisch angekoppelte Schwungmasse umschließt.

Bei der erfindungsgemäßen USV-Anlage ist ein besonders kompakter Aufbau des Motor/Generators bevorzugt, bei dem die Schwungmasse den Rotor des Motor/Generators umschließt. Anders gesagt ist bei der erfindungsgemäßen USV-Anlage die Masse des Rotors des Motor/Generators so weit erhöht, dass sie als mechanisch an den Rotor angekoppelte Schwungmasse wirksam ist, in deren Drehbewegung eine erhebliche kinetische Energie für die Notversorgung einer Last mit der USV-Anlage speicherbar ist. Die Schwungmasse, die an den Rotor des Motor/Generators angekoppelt ist, ist bei dieser Ausführungsform der erfindungsgemäßen USV-Anlage nicht ohne weiteres von dem Rotor abkoppelbar oder anderweitig trennbar, sondern bildet mit diesem eine geschlossene Baueinheit.

In dem Motor/Generator der erfindungsgemäßen USV-Anlage können die Statorkanäle mit den Gehäusekanälen parallel geschaltet sein. Vielfach ist es jedoch für eine Zwangsdurchströmung der Kühlmittelkanäle vorteilhaft, wenn die Statorkanäle mit den Gehäusekanälen in Reihe geschaltet sind. Dabei können die Statorkanäle stromab der Gehäusekanäle angeordnet sein.

Auch die Kühlkörper für die Leistungsendstufen können grundsätzlich mit den Kühlmittelkanälen in Reihe geschaltet sein, wobei die Kühlkörper stromab der Kühlmittelkanäle angeordnet sein können. Es kann jedoch bevorzugt sein, die Kühlkörper mit den Kühlmittelkanälen parallel zu schalten, um mit Hilfe von Ventilen in dem Kühlmittelkreislauf die Kühlmittelkühlung des Motor/Generators und der Leistungsendstufen nach den aktuellen Bedarfen unterschiedlich einstellen zu können.

Bei der erfindungsgemäßen USV-Anlage kann auch eine Kühlmittelkühlung für Filterinduktivitäten, die regelmäßig Teil des ausgangsseitigen DC/AC-Wandlers aber auch des eingangsseitigen AC/DC-Wandlers und damit ebenfalls in dem Maschinenschrank angeordnet sind, in den Kühlkreislauf integriert sein. Dabei kann es vorteilhaft sein, die Kühlmittelkühlung stromab der Kühlkörper für die Leistungsendstufen anzuordnen, weil die Filterinduktivitäten eine gewisse Temperaturerhöhung problemlos verkraften.

In dem Kühlmittelkreislauf wird vorzugsweise weiterhin ein Ausgleichsbehälter für das Kühlmittel angeordnet. Dieser kann optional ein komprimierbares Gasvolumen umfassen. Das Kühlmittel kann grundsätzlich gas- oder dampfförmig sein. Vorzugsweise handelt es sich aber um eine Kühlflüssigkeit.

Hinsichtlich der Kühlung mit Luft sind das Gebläse, die Luftfilter und weitere Luftführungseinrichtungen der erfindungsgemäßen USV-Anlage vorzugweise so angeordnet, dass sie mehrere Teilströme der Luft parallel zueinander durch den Maschinenschrank führen, die erst bei Eintritt der Luft in das Gebläse zusammengeführt werden. Einer dieser Teilströme der Luft durch den Maschinenschrank kann um den Motor/Generator herum führen und diesen zusätzlich zu der Kühlung mit dem Kühlmittel kühlen. Ein weiterer Teilstrom kann um die Filterinduktivitäten des DC/AC-Wandlers und/oder des AC/DC-Wandlers herum führen, um diese allein oder in Verbindung mit einer zusätzlichen Kühlmittelkühlung zu kühlen. Noch ein weiterer Teilstrom der Luft kann um den Bypassschalter des Bypasses herum führen, um diesen zu kühlen. Die Steuerung der USV-Anlage kann von noch einem weiteren Teilstrom der Luft gekühlt werden. Häufig reicht hier aber auch eine Konvektionskühlung aus, so dass auf eine Zwangsumwälzung der Luft im Bereich der Steuerung verzichtet werden kann.

Der Wärmetauscher in dem Kühlmittelkreislauf kann insbesondere stromab des Gebläses und damit in den zusammengeführten Teilströmen der Luft durch den Maschinenschrank angeordnet sein. In dem Wärmetauscher kann ein unmittelbarer Wärmeaustausch zwischen der Luft und dem Kühlmittel erfolgen. Die erfindungsgemäße USV-Anlage verzichtet also in der Regel auf die Verwendung eines zweiten Kühlmittels, das beispielsweise in einem Kreisprozess verdampft und wieder kondensiert werden könnte, um die Temperatur des in den Kühlmittelkreislauf geführten Kühlmittels unter die Temperatur der Luft abzusenken, die durch den Wärmetauscher geblasen wird.

Vorzugsweise umfasst der Maschinenschrank der erfindungsgemäßen USV-Anlage zwei nebeneinander angeordnete Teilschränke, die separate Transporteinheiten für die USV-Anlage ausbilden. Dabei kann eine Zwischenwand des Maschinenschranks durch zwei einander überlappende Wände der Teilschränke ausgebildet werden, die die Teilschränke gegeneinander abgrenzen, aber mit fluchtenden Luftdurchtrittsöffnungen versehen sind. Für den Transport der Teilschränke können diese Luftdurchtrittsöffnungen verschlossen sein.

Konkret kann der eine Teilschrank den Motor/Generator, das Gebläse, den Wärmetauscher und die Kühlmittelpumpe umschließen, d. h. alle Bestandteile der USV-Anlage mit beweglichen Teilen, während der andere Teilschrank die Endstufen, die Filterinduktivitäten des DC/AC-Wandlers und/oder des AC/DC-Wandlers, den Bypassschalter und die Steuerung umschließt, d. h. alle rein elektrischen bzw. elektronischen Bestandteile der USV-Anlage.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Wärmetauscher die Rede ist, ist dies so zu verstehen, dass genau ein Wärmetauscher, zwei Wärmetauscher oder mehr Wärmetauscher vorhanden sind. Die in den Patentansprüchen angeführten Merkmale können durch andere Merkmale ergänzt werden oder die einzigen Merkmale sein, die das jeweilige Erzeugnis aufweist.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: ist eine schematische Darstellung des Kühlsystems einer erfindungsgemäßen USV-Anlage.
- **Fig. 2**: ist eine schematische Darstellung des elektrischen und elektronischen Aufbaus der erfindungsgemäßen USV-Anlage gemäß Fig. 1.
- **Fig. 3**: zeigt einen Motor/Generator der erfindungsgemäßen USV-Anlage gemäß Fig. 1 in einer Ansicht von oben und
- **Fig. 4**: zeigt den Motor/Generator gemäß Fig. 3 in einer Schnittansicht gemäß einer in Fig. 3 eingezeichneten Schnittlinie A-A.

### FIGURENBESCHREIBUNG

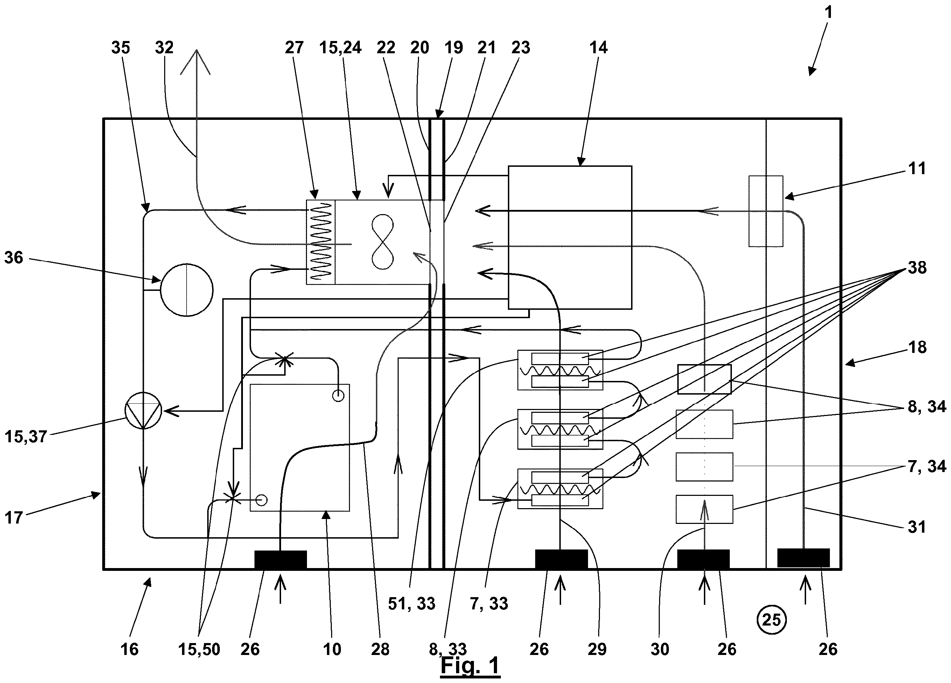

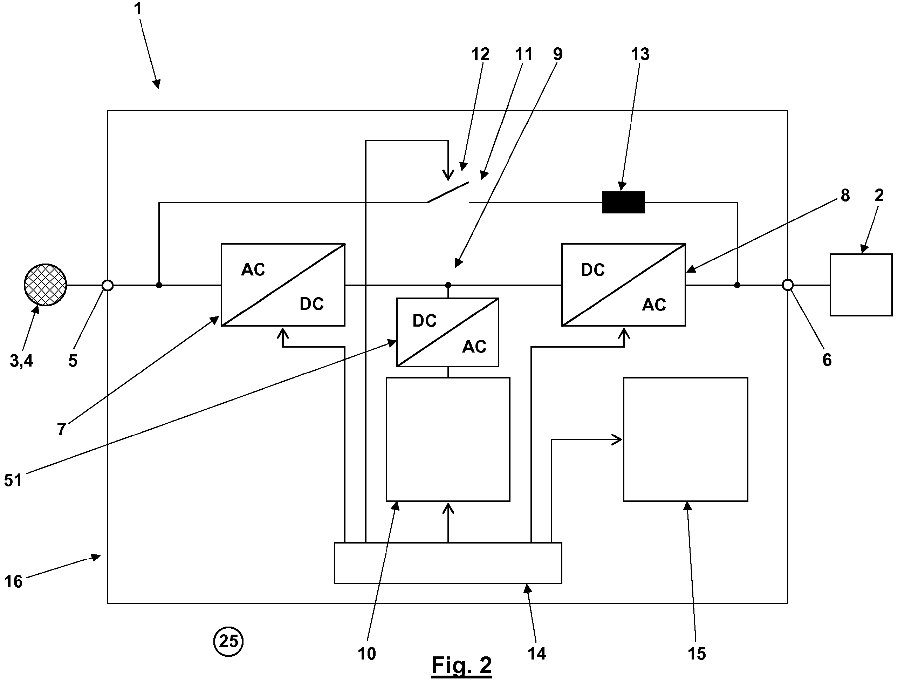

Die in den **Fig. 1** **und** **2** in Bezug auf unterschiedliche Aspekte dargestellte USV-Anlage 1 dient zur unterbrechungsfreien Versorgung einer Last 2 mit elektrischer Leistung. Dabei ist die USV-Anlage 1 zwischen die Last 2 und eine Hauptwechselstromquelle 3, beispielsweise ein öffentliches Wechselstromnetz 4, geschaltet, siehe Fig. 2. Zwischen einem Eingang 5 und einem Ausgang 6 weist die USV-Anlage 1 eine Reihenschaltung eines AC/DC-Wandlers 7 und eines DC/AC-Wandlers 8 auf, wobei an einen dazwischen liegenden Gleichspannungszwischenkreis 9 zusätzlich ein Motor/Generator 10 über einen bidirektionalen DC/AC-Wandler 51 angeschlossen ist. An den Rotor des Motor/Generators 10 ist eine Schwungmasse mechanisch angekoppelt, die im Betrieb des Motor/Generators 10 in Rotation versetzt wird. Die in der rotierenden Schwungmasse gespeicherte kinetische Energie kann über den als Generator betriebenen Motor/Generator 10 und den DC/AC-Wandler 8 zur Versorgung der Last 2 mit elektrischer Leistung genutzt werden, wenn die Hauptwechselstromquelle 3 ausfällt. Mit der Reihenschaltung des AC/DC-Wandlers 7 und des DC/AC-Wandlers 8 und unter Verwendung des Motor/Generators 10 kann die Qualität des Stroms aus der Hauptwechselstromquelle 3 verbessert und die Versorgung der Last 2 mit elektrischer Leistung stabilisiert werden, auch wenn die Hauptwechselstromquelle 3 nicht ausfällt. Weiterhin umfasst die USV-Anlage 1 einen Bypass 11 mit einem Bypassschalter 12, der parallel zu der Reihenschaltung des AC/DC-Wandlers 7 mit dem DC/AC-Wandler 8 vorgesehen ist und zur Überbrückung dieser Reihenschaltung dient, wenn die Last 2 direkt aus der Hauptwechselstromquelle 3 versorgt werden kann. Eine Grundversorgung der Last 2 aus der Hauptwechselstromquelle 3 unter Stabilisierung der an dem Ausgang 6 anliegenden Spannung mit Hilfe des DC/AC-Wandlers 8 wird durch eine zusätzliche Induktivität 13 in dem Bypass 11 ermöglicht. Für den AC/DC-Wandler 7, den DC/AC-Wandler 8, den Bypassschalter 12 und den Motor/Generator 10 ist eine Steuerung 14 der USV-Anlage 1 vorgesehen. Die Steuerung 14 steuert auch ein Kühlsystem 15 der USV-Anlage 1. Alle Bestandteile 7-15 der USV-Anlage 1 sind in einem Maschinenschrank 16 angeordnet.

Fig. 1 zeigt, dass dieser Maschinenschrank 16 zwei nebeneinander angeordnete Teilschränke 17 und 18 umfasst, wobei eine Zwischenwand 19 des Maschinenschranks 16 durch zwei überlappende Wände 20 und 21 der Teilschränke 17 und 18 ausgebildet ist, in denen fluchtende Luftdurchtrittsöffnungen 22 und 23 vorgesehen sind. In dem Teilschrank 17 sind alle Bestandteile der USV-Anlage 1 mit beweglichen Teilen angeordnet, während der Teilschrank 18 die rein elektrischen und elektronischen Bestandteile aufnimmt. Ein Gebläse 24 des Kühlsystems 15 in dem Teilschrank 17 saugt Luft aus einer Umgebung 25 durch Luftfilter 26 im Bereich des Bodens beider Teilschränke 17 und 18 in den Maschinenschrank 16 ein. Das Gebläse 24 bläst die Luft durch einen Wärmetauscher 27 und stößt sie dann wieder aus dem Maschinenschrank 16 aus. Dabei sind die Luftfilter 26, das Gebläse 24 und weitere, auch nicht dargestellte Luftführungseinrichtungen derart ausgebildet und angeordnet, dass mehrere Teilströme 28-31 der Luft durch den Maschinenschrank 16 verlaufen, bis sich alle Teilströme 28-31 beim Eintritt der Luft in das Gebläse 24 vereinigen, und ein vereinigter Hauptstrom 32 durch den Wärmetauscher 27 und aus dem Maschinenschrank 16 herausführt. Der eine Teilstrom 28 verläuft über den Motor/Generator 10. Der Teilstrom 29 verläuft über Leistungsendstufen 33 des AC/DC-Wandlers 7, des DC/AC-Wandlers 8 und des bidirektionalen DC/AC-Wandlers 51. Der Teilstrom 30 verläuft über Filterinduktivitäten 34 des AC/DC-Wandlers 7 und des DC/AC-Wandlers 8; und der Teilstrom 31 verläuft über den Bypass 11. Die Steuerung 14 kann von diesen oder einem weiteren der Teilströme der Luft durch den Maschinenschrank 16 überströmt werden oder außerhalb dieser Teilströme angeordnet sein und rein durch Konvektion gekühlt werden. Für den Motor/Generator 10 und die Leistungsendstufen 33 des DC/AC-Wandlers 8 ist ein zusätzlicher Kühlmittelkreislauf 35 vorgesehen, in dem der Wärmetauscher 27, ein Ausgleichsbehälter 36, eine Kühlmittelpumpe 37, Kühlmittelkanäle durch den Motor/Generator 10 und Kühlkörper 38 für die Leistungsendstufen 33 angeordnet sind. Dabei sind die Kühlkanäle durch den Motor/Generator 10 und die Kühlkörper 38 hier parallel geschaltet. Mit dem Kühlmittelkreislauf 35 werden die Bestandteile der USV-Anlage 1 selektiv zusätzlich mit Kühlmittel gekühlt, die bei einer hohen Leistungsdichte der USV-Anlage 1 am ehesten dazu neigen, zu überhitzen. Zur Steuerung des Kühlsystems 15 kann die Steuerung 14 neben dem Gebläse 24 auf die Kühlmittelpumpe 37 und auf Ventile 50, die die relative Durchströmung der Kühlmittelkanäle durch den Motor/Generator 10 gegenüber der Durchströmung der Kühlkörper 38 festlegen, einwirken. Die Ventile müssen aber nicht von der Steuerung 14 angesteuert werden, sondern können auch nur einmalig eingestellt werden, um die relativen Durchströmung der Kühlmittelkanäle durch den Motor/Generator 10 und der Kühlkörper 38 festzulegen.

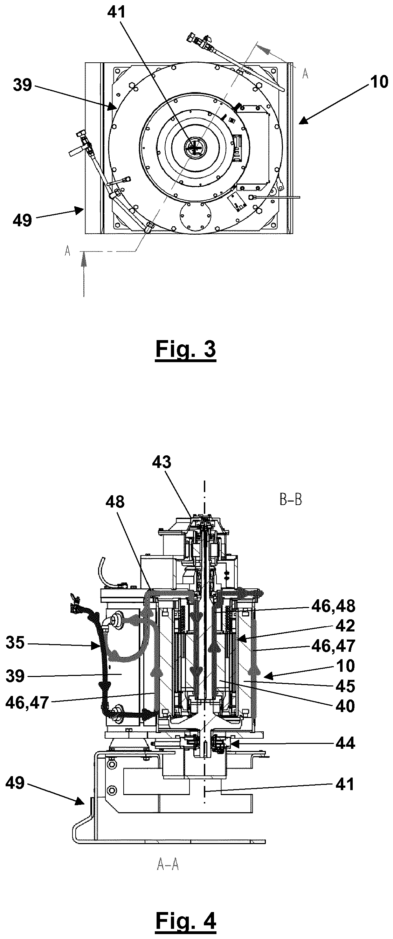

Die Fig. 3 zeigt den Motor/Generator 10 der USV-Anlage 1 in einer Ansicht von oben und Fig. 4 in einer Schnittansicht mit vertikalem Schnitt längs der Schnittlinie A-A gemäß Fig. 3. Der Motor/Generator 10 weist ein Gehäuse 39 auf, in dessen Mitte ein Stator 40 angeordnet ist. Um den Stator 40 herum ist um eine vertikale Drehachse 41 drehbar ein Rotor 42 in Drehlagern 43 und 44 gelagert. Der Rotor 42 ist mechanisch mit einer Schwungmasse 45 gekoppelt, die mit dem Rotor 42 die Drehachse 41 umläuft. Bei Betrieb des Motor/Generators 10 als Motor wird die Schwungmasse 45 in Rotation um die Drehachse 41 versetzt, um in der Schwungmasse 45 kinetische Energie zu speichern. Diese kinetische Energie kann wieder in elektrische Energie umgewandelt werden, wenn der Motor/Generator 10 als Generator betrieben wird. Die Kühlmittelkanäle 46 des Kühlmittelkreislaufs 35 durch den Motor/Generator 10 umfassen Gehäusekanäle 47 durch das Gehäuse 39 und zur Kühlung des Gehäuses 39 sowie Statorkanäle 48 durch den Stator 40. Weiter zeigt Fig. 4 ein unteres Auflager 49, über das der Motor/Generator 10 in dem Teilschrank 17 des Maschinenschranks 16 gelagert ist.

### BEZUGSZEICHENLISTE

- 1: USV-Anlage
- 2: Last
- 3: Hauptwechselstromquelle
- 4: öffentliches Stromnetz
- 5: Eingang
- 6: Ausgang
- 7: AC/DC-Wandler
- 8: DC/AC-Wandler
- 9: Gleichspannungszwischenkreis
- 10: Motor/Generator
- 11: Bypass
- 12: Bypassschalter
- 13: Induktivität
- 14: Steuerung
- 15: Kühlsystem
- 16: Maschinenschrank
- 17: Teilschrank
- 18: Teilschrank
- 19: Zwischenwand
- 20: Wand
- 21: Wand
- 22: Luftdurchtrittsöffnung
- 23: Luftdurchtrittsöffnung
- 24: Gebläse
- 25: Umgebung
- 26: Luftfilter
- 27: Wärmetauscher
- 28: Teilstrom
- 29: Teilstrom
- 30: Teilstrom
- 31: Teilstrom
- 32: Hauptstrom
- 33: Leistungsendstufe
- 34: Filterinduktivität
- 35: Kühlmittelkreislauf
- 36: Ausgleichsbehälter
- 37: Kühlmittelpumpe
- 38: Kühlkörper
- 39: Gehäuse
- 40: Stator
- 41: Drehachse
- 42: Rotor
- 43: Drehlager
- 44: Drehlager
- 45: Schwungmasse
- 46: Kühlmittelkanal
- 47: Gehäusekanal
- 48: Statorkanal
- 49: Auflager
- 50: Ventil
- 51: bidirektionaler DC/AC-Wandler

## Patentansprüche

1. USV-Anlage (1) mit einem Maschinenschrank (16) und den folgenden Bestandteilen, die in dem Maschinenschrank (16) angeordnet sind:
- ein ausgangsseitig an einen Gleichspannungszwischenkreis (9) angeschlossener AC/DC-Wandler (7) mit einer Leistungsendstufe (33),
- ein eingangsseitig an den Gleichspannungszwischenkreis (9) angeschlossener DC/AC-Wandler (8) mit einer weiteren Leistungsendstufe (33),
- ein an den Gleichspannungszwischenkreis (9) angeschlossener bidirektionaler DC/AC-Wandler (51) mit noch einer weiteren Leistungsendstufe (33),
- ein Bypass (11) zu der Reihenschaltung des AC/DC-Wandlers (7) mit dem DC/AC-Wandler (8), in dem ein Bypassschalter (12) angeordnet ist,
- eine Steuerung (14) für den AC/DC-Wandler (7), den DC/AC-Wandler (8) und den Bypassschalter (12) sowie
- ein Luft aus einer Umgebung (25) des Maschinenschranks (16) durch Luftfilter (26) in den Maschinenschrank (16) einsaugendes, die Luft in dem Maschinenschrank (16) durch einen Wärmetauscher (27) blasendes und die Luft wieder aus dem Maschinenschrank (16) ausstoßendes Gebläse (24),
- einem Kühlmittelkreislauf (35), in dem der Wärmetauscher (27) zusammen mit einer Kühlmittelpumpe (37) und Kühlkörpern (38) für die Leistungsendstufen (33) angeordnet ist, **dadurch gekennzeichnet,**
- **dass** ein Motor/Generator (10), der in dem Maschinenschrank (16) angeordnet ist, für den die Steuerung (14) ebenfalls vorgesehen ist und an dessen Rotor (42) eine Schwungmasse (45) mechanisch angekoppelt ist, AC-seitig an den bidirektionalen DC/AC-Wandler (51) angeschlossen ist und
- **dass** Kühlmittelkanälen (46) durch den Motor/Generator (10) in dem Kühlmittelkreislauf (35) angeordnet sind, wobei die Kühlmittelkanäle (46) Statorkanäle (48) umfassen, die durch einen Stator (40) des Motor/Generators (10) verlaufen.

2. USV-Anlage (1) nach Anspruch 1, **dadurch gekennzeichnet, dass** die Kühlmittelkanäle (46) Gehäusekanäle (47) umfassen, die durch ein Gehäuse (39) des Motor/Generators (10) verlaufen.

3. USV-Anlage (1) nach Anspruch 2, **dadurch gekennzeichnet, dass** das Gehäuse (39) den Rotor (42) und die daran angekoppelte Schwungmasse (45) umschließt.

4. USV-Anlage (1) nach Anspruch 2 oder 3, **dadurch gekennzeichnet, dass** die Statorkanäle (48) mit den Gehäusekanälen (47) parallel geschaltet sind oder dass die Statorkanäle (48) mit den Gehäusekanälen (47) in Reihe geschaltet sind.

5. USV-Anlage (1) nach Anspruch 2 oder 3, **dadurch gekennzeichnet, dass** die Statorkanäle (48) mit den Gehäusekanälen (47) in Reihe geschaltet sind, wobei die Statorkanäle (48) stromab der Gehäusekanäle (47) angeordnet sind.

6. USV-Anlage (1) nach einem der vorhergehenden Ansprüche, **dadurch gekennzeichnet, dass** die Schwungmasse (45) den Rotor (42) des Motor/Generators (10) umschließt.

7. USV-Anlage (1) nach einem der vorhergehenden Ansprüche, **dadurch gekennzeichnet, dass** die Kühlkörper (38) mit den Kühlmittelkanälen (46) parallel geschaltet sind oder dass die Kühlkörper (38) mit den Kühlmittelkanälen (46) in Reihe geschaltet sind, wobei die Kühlkörper (38) optional stromab der Kühlmittelkanäle (46) angeordnet sind.

8. USV-Anlage (1) nach einem der vorhergehenden Ansprüche, **dadurch gekennzeichnet, dass** in dem Kühlmittelkreislauf (35) eine Kühlmittelkühlung für Filterinduktivitäten (34) des AC/DC-Wandlers (7) und/oder des DC/AC-Wandlers (8) angeordnet ist, wobei die Kühlmittelkühlung optional stromab der Kühlkörper (38) angeordnet ist.

9. USV-Anlage (1) nach einem der vorhergehenden Ansprüche, **dadurch gekennzeichnet, dass** in dem Kühlmittelkreislauf (35) ein Ausgleichsbehälter (36) angeordnet ist, der optional in komprimierbares Gasvolumen umfasst.

10. USV-Anlage (1) nach einem der vorhergehenden Ansprüche, **dadurch gekennzeichnet, dass** das Gebläse (24), die Luftfilter (26) und weitere Luftführungseinrichtungen so angeordnet und ausgebildet sind, dass sie einen ersten Teilstrom (28) der Luft durch den Maschinenschrank (16) um den Motor/Generator (10) herum führen.

11. USV-Anlage (1) nach einem der vorhergehenden Ansprüche, **dadurch gekennzeichnet, dass** das Gebläse (24), die Luftfilter (26) und weitere Luftführungseinrichtungen so angeordnet und ausgebildet sind, dass sie einen zweiten Teilstrom (30) der Luft durch den Maschinenschrank (16) um Filterinduktivitäten (34) des AC/DC-Wandlers (7) und/oder des DC/AC-Wandlers (8) herum führen.

12. USV-Anlage (1) nach einem der vorhergehenden Ansprüche, **dadurch gekennzeichnet, dass** das Gebläse (24), die Luftfilter (26) und weitere Luftführungseinrichtungen so angeordnet und ausgebildet sind, dass sie einen dritten Teilstrom (31) der Luft durch den Maschinenschrank (16) um den Bypassschalter (12) herum führen.

13. USV-Anlage (1) nach einem der Ansprüche 10 bis 12, **dadurch gekennzeichnet, dass** das Gebläse (24) und die weiteren Luftführungseinrichtungen so angeordnet und ausgebildet sind, dass sie alle Teilströme (28, 29, 30, 31) beim Eintritt der Luft in das Gebläse (24) zusammenführen, wobei der Wärmetauscher (27) optional stromab des Gebläses (24) angeordnet ist.

14. USV-Anlage (1) nach einem der vorhergehenden Ansprüche, **dadurch gekennzeichnet, dass** der Maschinenschrank (16) zwei nebeneinander angeordnete Teilschränke (17, 18) aufweist, wobei eine Zwischenwand (19) des Maschinenschranks (16) durch zwei einander überlappende Wände (20, 21) der Teilschränke (17, 18) mit fluchtenden Luftdurchtrittsöffnungen (22, 23) ausgebildet ist.

15. USV-Anlage (1) nach Anspruch 14, **dadurch gekennzeichnet, dass** der eine Teilschrank (17) den Motor/Generator (10), das Gebläse (24), den Wärmetauscher (27) und die Kühlmittelpumpe (37) umschließt und dass der andere Teilschrank (18) die Leistungsendstufen (33), Filterinduktivitäten (34) des AC/DC-Wandlers (7) und/oder des DC/AC-Wandlers (8), den Bypassschalter (12) und die Steuerung (14) umschließt.

## Claims

1. UPS installation (1) comprising a machine cabinet (16) and the following components which are arranged in the machine cabinet (16):
- an AC-to-DC converter (7) having a power output stage (33) and connected to a DC voltage link (33) on its output side,
- a DC-to-AC converter (8) having a further power output stage (33) and connected to the DC voltage link (9) on its input side,
- a bidirectional DC-to-AC converter (51) having an even further power output stage (33) and connected to the DC voltage link (9),
- a bypass (11) to the AC-to-DC converter (7) and the DC-to-AC converter (8) connected in series, in which a bypass switch (12) is arranged,
- a controller (14) for the AC-to-DC converter (7), the DC-to-AC converter (8), and the bypass switch (12) and
- a blower (24) drawing air out of surroundings (25) of the machine cabinet (16) through air filters (26) into the machine cabinet (16), blowing the air within the machine cabinet (16) through a heat exchanger (27) and ejecting the air out of the machine cabinet (16) again,
- a coolant circuit (35), in which the heat exchanger (27) is arranged together with a coolant pump (37) and cooling bodies (38) for the power output stages (33),
**characterized in**
- **that** a motor/generator (10), which is arranged in the machine cabinet (16), for which the controller (14) is also provided, and which has a rotor (42) to which a flywheel (45) is mechanically coupled, is connected to the bidirectional DC-to-AC converter (51) at its AC side,
- **that** coolant channels (46) through the motor/generator (10) are arranged in the coolant circuit (35), wherein the coolant channels (46) include stator channels (48) which run through a stator (40) of the motor/generator (10).

2. UPS installation (1) according to claim 1, **characterized in that** the coolant channels (46) include housing channels (47) which run through a housing (39) of the motor/generator (10).

3. UPS installation (1) according to claim 2, **characterized in that** the housing (39) encloses the rotor (42) and the flywheel (45) coupled thereto.

4. UPS installation (1) according to claim 2 or 3, **characterized in** the stator channels (48) are connected in parallel to the housing channels (47), or that the stator channels (48) and the housing channel (47) are connected in series.

5. UPS installation (1) according to claim 2 or 3, **characterized in that** the stator channels (48) and the housing channels (47) are connected in series, wherein the stator channels (48) are arranged downstream of the housing channels (47).

6. UPS installation (1) according to any of the preceding claims, **characterized in that** the flywheel (45) encloses the rotor (42) of the rotor/generator (10).

7. UPS installation (1) according to any of the preceding claims, **characterized in that** the cooling bodies (38) and the coolant channels (46) are connected in parallel, or that the cooling channels (38) and the coolant channels (46) are connected in series, wherein the cooling bodies (38) are optionally arranged downstream of the cooling channels (46).

8. UPS installation (1) according to any of the preceding claims, **characterized in that** a coolant cooling for filter inductors (34) of the AC-to-DC converter (7) and/or of the DC-to-AC converter (8) is arranged in the coolant circuit (35), wherein the coolant cooling is optionally arranged downstream of the cooling bodies (38).

9. UPS installation (1) according to any of the preceding claims, **characterized in that** a compensation reservoir (36), which optionally includes a compressible gas volume, is arranged in the coolant circuit (35).

10. UPS installation (1) according to any of the preceding claims, **characterized in that** the blower (24), the air filters (26) and further air guiding devices are arranged and designed such that they lead a first partial flow (28) of the air through the machine cabinet (16) around the motor/generator (10).

11. UPS installation (1) according to any of the preceding claims, **characterized in that** the blower (24), the air filters (26) and further air guiding devices are arranged and designed such that they lead a second partial flow (30) of the air through the machine cabinet (16) around filter inductors (34) of the AC-to-DC converter (7) and/or the DC-to-AC converter (8).

12. UPS installation (1) according to any of the preceding claims, **characterized in that** the blower (24), the air filters (26) and further air guiding devices are arranged and designed such that they a lead a third partial flow (31) of the air through the machine cabinet (16) around the bypass switch (12).

13. UPS installation (1) according to any of the claims 10 to 12, **characterized in that** the blower (24) and the further air guiding devices are arranged and designed such that they merge all partial flows (28, 29, 30, 31) upon entry of the air in the blower (27), wherein the heat exchanger (27) is optionally arranged downstream of the blower (24).

14. UPS installation (1) according to any of the preceding claims, **characterized in that** the machine cabinet (16) comprises two partial cabinet (17, 18) arranged side by side, wherein a partition wall (19) of the machine cabinet (16) is formed by two overlapping walls (20, 21) of the partial cabinets (17, 18) having aligned air passage openings (22, 23).

15. UPS installation (1) according to claims 14, **characterized in that** the one partial cabinet (17) encloses the motor/generator (10), the blower (24), the heat exchanger (27) and the coolant pump (37), and that the other partial cabinet (18) encloses the power output stages (33), filter inductors (34) of the AC-to-DC converter (7) and/or the DC-to-AC converter (8), the bypass switch (12) and the controller (14).

## Revendications

1. Installation ASI (1) avec une armoire de machine (16) et composants suivants, qui sont disposés dans l'armoire de machine (16) :
- un convertisseur AC/DC (7), avec un étage final de puissance (33), raccordé côté sortie à un circuit intermédiaire de tension continue (9),
- un convertisseur DC/AC (8), avec un autre étage final de puissance (33), raccordé côté entrée au circuit intermédiaire de tension continue (9),
- un convertisseur bidirectionnel DC/AC (51), avec encore un autre étage final de puissance (33), raccordé au circuit intermédiaire de tension continue (9),
- une dérivation (11) pour le branchement en série du convertisseur AC/DC (7) avec le convertisseur DC/AC (8), dans lequel est disposé un commutateur de dérivation (12),
- une commande (14) pour le convertisseur AC/DC (7), le convertisseur DC/AC (8) et le commutateur de dérivation (12) ainsi que
- un ventilateur (24) aspirant l'air d'un environnement (25) de l'armoire de machine (16) à travers des filtres à air (26) vers l'armoire de machine (16), soufflant l'air dans l'armoire de machine (16) à travers un échangeur de chaleur (27) et expulsant l'air hors de l'armoire de machine (16),
- un circuit de produit de refroidissement (35) dans lequel l'échangeur de chaleur (27) est disposé conjointement avec une pompe de produit de refroidissement (37) et des radiateurs (38) pour les étages finaux de puissance (33),
**caractérisée en ce que**
- un moteur/générateur (10), qui est disposé dans l'armoire de machine (16), pour lequel la commande (14) est également prévue, et au rotor (42) duquel est couplée mécaniquement une masse d'inertie (45), est raccordé côté AC au convertisseur bidirectionnel DC/AC (51) et
- des canaux de produit de refroidissement (46) sont disposés à travers le moteur/générateur (10) dans le circuit de produit de refroidissement (35), dans lequel les canaux de produit de refroidissement (46) comprennent des canaux de stator (48) qui s'étendent à travers un stator (40) du moteur/générateur (10).

2. Installation ASI (1) selon la revendication 1, **caractérisée en ce que** les canaux de produit de refroidissement (46) comprennent des canaux de boîtier (47) qui s'étendent à travers un boîtier (39) du moteur/générateur (10).

3. Installation ASI (1) selon la revendication 2, **caractérisée en ce que** le boîtier (39) entoure le rotor (42) et la masse d'inertie (45) qui y est couplée.

4. Installation ASI (1) selon la revendication 2 ou 3, **caractérisée en ce que** les canaux de stator (48) sont branchés en parallèle avec les canaux de boîtier (47) ou **en ce que** les canaux de stator (48) sont branchés en série avec les canaux de boîtier (47).

5. Installation ASI (1) selon la revendication 2 ou 3, **caractérisée en ce que** les canaux de stator (48) sont branchés en série avec les canaux de boîtier (47), dans lequel les canaux de stator (48) sont disposés en aval des canaux de boîtier (47).

6. Installation ASI (1) selon l'une des revendications précédentes, **caractérisée en ce que** la masse d'inertie (45) entoure le rotor (42) du moteur/générateur (10).

7. Installation ASI (1) selon l'une des revendications précédentes, **caractérisée en ce que** les radiateurs (38) sont branchés en parallèle avec les canaux de produit de refroidissement (46) ou **en ce que** les radiateurs (38) sont branchés en série avec les canaux de produit de refroidissement (46), dans lequel les radiateurs (38) sont disposés, de manière optionnelle, en aval des canaux de produit de refroidissement (46).

8. Installation ASI (1) selon l'une des revendications précédentes, **caractérisée en ce que**, dans le circuit de produit de refroidissement (35), est disposé un refroidissement de produit de refroidissement pour des inductances de filtrage (34) du convertisseur AC/DC (7) et/ou du convertisseur DC/AC (8), dans lequel le refroidissement de produit de refroidissement est disposé, de manière optionnelle, en aval des radiateurs (38).

9. Installation ASI (1) selon l'une des revendications précédentes, **caractérisée en ce que**, dans le circuit de produit de refroidissement (35), est disposé un récipient d'équilibrage (36), qui comprend, de manière optionnelle, un volume de gaz compressible.

10. Installation ASI (1) selon l'une des revendications précédentes, **caractérisée en ce que** le ventilateur (24), les filtres à air (26) et les autres dispositifs de guidage de l'air sont disposés et conçus de façon à guider un premier flux d'air partiel (28) de l'air à travers l'armoire de machine (16) autour du moteur/générateur (10).

11. Installation ASI (1) selon l'une des revendications précédentes, **caractérisée en ce que** le ventilateur (24), les filtres à air (26) et les autres dispositifs de guidage de l'air sont disposés et conçus de façon à guider un deuxième flux d'air partiel (30) de l'air à travers l'armoire de machine (16) autour d'inductances de filtrage (34) du convertisseur AC/DC (7) et/ou du convertisseur DC/AC (8).

12. Installation ASI (1) selon l'une des revendications précédentes, **caractérisée en ce que** le ventilateur (24), les filtres à air (26) et les autres dispositifs de guidage de l'air sont disposés et conçus de façon à guider un troisième flux d'air partiel (31) de l'air à travers l'armoire de machine (16) autour du commutateur de dérivation (12).

13. Installation ASI (1) selon l'une des revendications 10 à 12, **caractérisée en ce que** le ventilateur (24) et les autres dispositifs de guidage de l'air sont disposés et conçus de façon à regrouper tous les flux partiels (28, 29, 30, 31) lors de l'entrée de l'air dans le ventilateur (24), dans laquelle l'échangeur de chaleur (27) est disposé, de manière optionnelle, en aval du ventilateur (24).

14. Installation ASI (1) selon l'une des revendications précédentes, **caractérisée en ce que** l'armoire de machine (16) comprend deux armoires partielles (17, 18) juxtaposées, dans laquelle une paroi intermédiaire (19) de l'armoire de machine (16) est constituée de deux parois (20, 21), se chevauchant entre elles, des armoires partielles (17, 18), avec des ouvertures de passage d'air (22, 23) alignées.

15. Installation ASI (1) selon la revendication 14, **caractérisée en ce qu'**une armoire partielle (17) entoure le moteur/générateur (10), le ventilateur (24), l'échangeur de chaleur (27) et la pompe de produit de refroidissement (37) et **en ce que** l'autre armoire partielle (18) entoure les étages finaux de puissance (33), les inductances de filtrage (34) du convertisseur AC/DC (7) et/ou du convertisseur DC/AC (8), le commutateur de dérivation (12) et la commande (14).
